**Europäisches Patentamt**

**European Patent Office**

**Office européen des brevets**

(11) Veröffentlichungsnummer: **0 133 555**
**B1**

(12) **EUROPÄISCHE PATENTSCHRIFT**

(45) Veröffentlichungstag der Patentschrift:
**22.06.88**

(51) Int. Cl.⁴: **H 05 K 9/00**

(21) Anmeldenummer: **84109196.0**

(22) Anmeldetag: **02.08.84**

(54) Hochfrequenzdichte Abschirmung von Flächenteilen.

(30) Priorität: **05.08.83 DE 3328386**

(43) Veröffentlichungstag der Anmeldung:
**27.02.85 Patentblatt 85/9**

(45) Bekanntmachung des Hinweises auf die Patenterteilung:
**22.06.88 Patentblatt 88/25**

(84) Benannte Vertragsstaaten:
**AT BE CH DE FR GB IT LI NL SE**

(56) Entgegenhaltungen:
**EP - A - 0 098 212**
**AT - A - 374 655**
**CH - A - 320 966**
**FR - A - 2 200 728**

(73) Patentinhaber: **Siemens Aktiengesellschaft Berlin und München, Wittelsbacherplatz 2, D-8000 München 2 (DE)**

(72) Erfinder: **Schmalzl, Dieter, Reichenaustrasse 33, D-8000 München 60 (DE)**

## Beschreibung

Die Erfindung betrifft eine hochfrequenzdichte Abschirmung von Flächenteilen bei Gerüst- und Blechkonstruktionen für elektronische Geräte, insbesondere der Datentechnik, wobei an den Berührungsstellen zwischen Gerüst und Flächenteil mindestens eine Feder, die in der Mitte eine Wölbung aufweist, befestigbar ist.

Aus der französischen Patentschrift 2 200 728 ist ein gegen hochfrequente elektromagnetische Störstrahlung abgeschirmtes Gehäuse für elektrische Geräte bekannt, das durch mindestens eine Tür frei zugänglich ist, die an ihrer Auflagefläche an dem Gehäuse eine in eine Vielzahl von Segmenten unterteilte elektrisch leitfähige Kontaktfederanordnung trägt, um an der ganzen Auflagefläche einen niedrigen Übergangswiderstand zwischen der Tür und dem Gehäuse zu gewährleisten. Dabei weist der Türrahmen auf der Innenseite einen Längsschlitz und parallel dazu verlaufend einen U-förmig gebogenen Winkel mit der Öffnung in Richtung auf den Längsschlitz auf, wobei eine abgeknickte Kontaktfeder, deren seitliche Enden in den Längsschlitzen bzw. den Winkel unter federnder Vorspannung formschlüssig eingespannt sind, den Kontakt zwischen dem Türrahmen und dem Gehäuse herstellt. Dadurch wird eine Abschirmung gegen hochfrequente elektromagnetische Störstrahlung erreicht.

Aufgabe der Erfindung ist es, ein leicht austauschbares Kontaktteil für die hochfrequenzsichere Schirmung von Abdeckungen elektronischer Geräte zu schaffen.

Zur Lösung dieser Aufgabe wird die HF-dichte Abschirmung gemäss der Erfindung derart ausgebildet, dass im Flächenteil mindestens eine als Kontaktteil dienende Feder befestigbar ist, die nach oben eine Wölbung und an beiden Enden hakenförmige Abbiegungen, die in Durchbrüche des Flächenteils eingreifen, aufweist, und dass die Feder so in die Durchbrüche der Flächenteile eingesteckt sind, dass bei entspannter Feder die Wölbung über das Flächenteil hinausragt und die hakenförmigen Abbiegungen eine Arretierung zur Verhinderung des Herausfallens der Feder bilden.

Die Abbiegungen der Feder können Z-förmig und axialsymmetrisch ausgebildet sein. Eine weitere Ausführungsform sieht vor, dass die Abbiegung an den Federenden Z-förmig, richtungsgleich und mit schräg nach unten verlaufenden Enden ausgebildet ist.

Eine andere Ausführungsform ist so ausgebildet, dass die Abbiegung des einen Federendes durch einen Durchbruch in Gegenrichtung hindurchgeführt oder um eine Blechkante herumgeführt ist und auf der Wölbungsseite der Feder umgebogen ist und dass die als Höcker ausgebildete Wölbung im zweiten Durchbruch einrastet.

In einer weiteren Ausgestaltung kann die Feder auch so ausgebildet sein, dass die Abbiegung an den Federenden richtungsgleich und parallel zur Flächenteilinnenseite verlaufend ausgebildet ist.

Durch diese Massnahmen erhält man eine einzelne in einem Blechdurchbruch bzw. an einer Blechkante einschnappbare Metallfeder, die sich durch ihre Form in der Lochung durch Rasten verankert und fixiert, an der Blechoberfläche eine Überdehnungsauflage findet und weitgehend unempfindlich ist. Die Anlage sowohl in der Abdeckung als auch am Gerät bildet einen festen Kontakt. Die Feder ist leicht einbau- bzw. austauschbar und daher in Vorrichtungen zur Montagevereinfachung vorgesehen. Sie lässt einen grossen Toleranzausgleich zu, und da sie trotz eines grossen Federweges nach hinten wenig in die Fassaden eintaucht, ist sie auch für dünne Abdeckungen anwendbar.

Zur Befestigung der Feder wird lediglich nur ein Formloch benötigt, das bei allgemeinen Lochungen der Blechteile fast ohne zusätzlichen Aufwand gefertigt werden kann. Dieses Formloch kann bei der Herstellung umlaufend an der Abdeckung angebracht werden, so dass je nach Anforderung der eingebauten Elektronik die Bestückung mit mehr oder weniger Federn erfolgen kann.

Erhält das Formloch beim Stanzen eine Prägung wie oben angeführt, so kann die Schirmwirkung durch den geringen Abstand zwischen Abdeckung und Gerät erhöht werden, da die Feder in die Prägung eintaucht.

Anhand der Ausführungsbeispiele nach den Figuren 1 bis 4 wird die Erfindung näher erläutert.

Es zeigen:

Fig. 1 eine Feder mit nach oben gerichteter Wölbung und Z-förmig abgebogenen Federenden,

Fig. 2 eine Ausführungsform, bei der Abbiegungen in gleicher Richtung vorgenommen sind,

Fig. 3 eine Ausführungsform, bei der ein Ende eine Biegung um 180° aufweist,

Fig. 4 eine Abart der Feder nach Fig. 2.

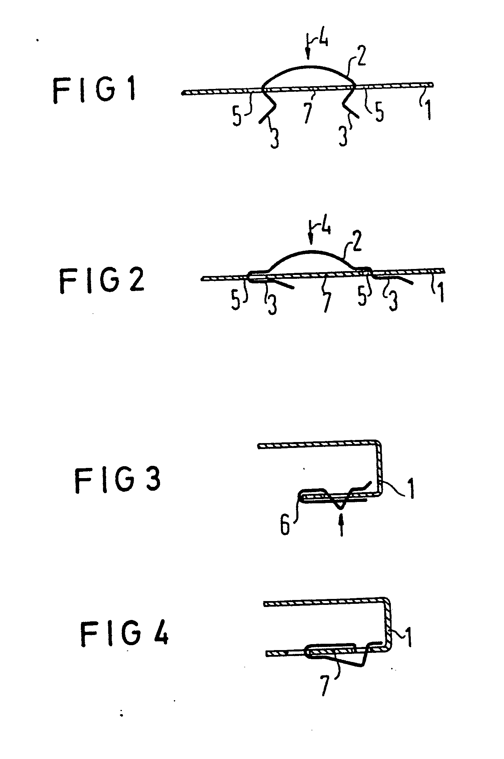

In Fig. 1 ist eine Ausführungsform der Feder 2 nach der Erfindung dargestellt, die eine Wölbung 4 aufweist und deren beide Federenden Z-förmige Abbiegungen 3 aufweisen, die durch die Durchbrüche 5 des Flächenteils 1 hindurchgesteckt werden. Die Feder 2 hängt im entspannten Zustand mit ihren Enden 3 in den Durchbrüchen 5 und ist damit vor dem Herausfallen arretiert. Beim Anbringen des Flächenteils 1 an ein nichtdargestelltes Gerüst wird die Wölbung der Feder 4 flachgedrückt, wodurch ein Andruckkontakt zwischen dem Flächenteil 1 und dem Gerüst entsteht. Die beiden Z-förmigen Abbiegungen 5 hintergreifen dann das Flächenteil 1 und sorgen ebenfalls für eine stabile Lage der Federn.

Fig. 2 zeigt eine Feder, bei der die beiden Enden in gleicher Richtung abgebogen sind. Die Feder wird zunächst mit dem einen Ende in den einen Durchbruch 5 eingesetzt und dann mit dem anderen Ende in den weiteren Durchbruch 5 eingerastet. Sie umfasst auf der einen Seite den Steg 7 des Flächenteiles 1, während die Enden 3 der Feder 2 auf der anderen Seite sich gegen die Flä-

3  0 133 555  4

chenteilinnenwand drücken, wodurch die Feder ebenfalls arretiert ist.

Fig. 3 zeigt eine Feder, die entweder mit ihren Federenden durch zwei Durchbrüche 6 hindurchgeführt ist, wobei das eine Federende um 180° gedreht in Richtung des anderen Federendes zurückgeführt ist und im zweiten Durchbruch einrastet, oder anstelle des ersten Durchbruchs um eine Kante gelegt ist und dann in gleicher Weise wie vorstehend beschrieben geführt ist.

Eine weitere Ausführungsform zeigt die Fig. 4. Bei dieser sind die beiden Enden der Feder in der gleichen Richtung abgebogen, wobei jedoch das eine Ende um den zwischen den beiden Durchbrüchen liegenden Steg 7 herumgewunden ist, wodurch die Feder gehalten wird.

Alle Federn können auch aus Federdraht hergestellt werden.

## Patentansprüche

1. Hochfrequenzdichte Abschirmung von Flächenteilen bei Gerüst- und Blechkonstruktionen für elektronische Geräte, insbesondere der Datentechnik, wobei an den Berührungsstellen zwischen Gerüst und Flächenteil mindestens eine Feder, die in der Mitte eine Wölbung aufweist, befestigbar ist, dadurch gekennzeichnet, dass an den Berührungsstellen zwischen Gerüst und Flächenteilen im Flächenteil (1) mindestens eine als Kontaktteil dienende Feder (2) befestigbar ist, die in der Mitte eine Wölbung (4) und an beiden Enden hakenförmige Abbiegungen (3), die in Durchbrüche (5) des Flächenteils (1) eingreifen, aufweist, und dass die Feder (2) so in die Durchbrüche (5) der Flächenteile (1) eingesteckt ist, dass bei entspannter Feder die Wölbung (4) über das Flächenteil (1) hinausragt und die hakenförmigen Abbiegungen (3) eine Arretierung zur Verhinderung des Herausfallens der Feder (2) bilden.

2. Hochfrequenzdichte Abschirmung nach Anspruch 1, dadurch gekennzeichnet, dass die Abbiegungen (3) der Feder (2) Z-förmig und axialsymmetrisch ausgebildet sind.

3. Hochfrequenzdichte Abschirmung nach Anspruch 1, dadurch gekennzeichnet, dass die Abbiegung (3) an den Federenden Z-förmig, richtungsgleich und mit schräg nach unten verlaufenden Enden ausgebildet ist.

4. Hochfrequenzdichte Abschirmung nach Anspruch 1, dadurch gekennzeichnet, dass die Abbiegung (3) des einen Federendes durch einen Durchbruch (6) in Gegenrichtung hindurchgeführt oder um eine Blechkante herumgeführt ist und auf der Wölbungsseite der Feder umgebogen ist und dass die als Höcker ausgebildete Wölbung im zweiten Durchbruch einrastet.

5. Hochfrequenzdichte Abschirmung nach Anspruch 1, dadurch gekennzeichnet, dass die Abbiegung (3) an den Federenden richtungsgleich und parallel zur Flächenteilinnenseite verlaufend ausgebildet ist.

## Claims

1. High-frequency shield of surface parts on frame and sheet-metal structures for electronic equipment, especially in data systems engineering, at least one spring, having an arch in the centre, being fastenable at the points of contact between frame and surface part, characterized in that at least one spring (2) serving as a contact part can be fastened in the surface part (1) at the points of contact between frame and surface parts and has, in the centre, an arch (4) and, at both ends, hook-shaped bent portions (3) engaging into perforations (5) in the surface part (1), and in that the spring (2) is inserted into the perforations (5) of the surface parts (1) in such a way that, when the spring is relaxed, the arch (4) projects above the surface part (1) and the hook-shaped bent portions (3) form a retention means for preventing the spring (2) from falling out.

2. High-frequency shield according to Claim 1, characterized in that the bent portions (3) of the spring (2) are made Z-shaped and axially symmetrical.

3. High-frequency shield according to Claim 1, characterized in that the bent portions (3) at the spring ends are made Z-shaped, point in the same direction and have ends extending obliquely downwards.

4. High-frequency shield according to Claim 1, characterized in that the bent portion (3) of one spring end is guided through one perforation (6) in the opposite direction or is guided round one edge of the metal sheet and is bent round on the arch side of the spring, and in that the arch taking the form of a hump engages in the second perforation.

5. High-frequency shield according to Claim 1, characterized in that the bent portions (3) at the spring ends point in the same direction and extend parallel to the inner face of the surface part.

## Revendications

1. Blindage contre des hautes fréquences pour des surfaces planes de constructions en treillis et en tôles pour des appareils électroniques, en particulier de la technique des données, du type dans lequel au moins un ressort qui comporte dans sa partie médiane un bombement, est susceptible d'être fixé aux emplacements de contact entre le treillis et l'élément de surface plane, caractérisé par le fait qu'en ces emplacements est susceptible d'être fixé dans l'élément de surface plane (1) au moins un ressort (2) servant d'élément de contact et comportant en son milieu un bombement (4) et aux deux extrémités des parties coudées (3) en forme de crochets qui pénètrent dans des ouvertures (5) ménagées dans l'élément de surface plane (1) et que le ressort (2) est engagé de telle façon dans les ouvertures (5) de l'élément de surface plane que lorsque le ressort est détendu, le bombement (4) déborde l'élément de surface plane (1), alors que les parties coudées (3) en forme de crochets constituent des éléments d'arrêt pour empêcher la chute du ressort.

2. Blindage contre des hautes fréquences selon la revendication 1, caractérisé par le fait que
les parties coudées (3) du ressort (2) sont en forme de Z avec symétrie axiale.

3. Blindage contre des hautes fréquences selon
la revendication 1, caractérisé par le fait que les
parties coudées (3) aux extrémités sont réalisées
en forme de Z, dans la même direction et avec
des extrémités s'étendant obliquement vers le
bas.

4. Blindage contre des hautes fréquences selon la revendication 1, caractérisé par le fait que
la partie coudée (3) de l'une des extrémités du
ressort passe à travers une ouverture (6) et en
sens opposé ou est passé autour d'un bord de
tôle et est recourbée sur le côté à bombement du
ressort, et que le bombement, réalisé sous la forme d'un pic, s'enclenche dans la seconde ouverture.

5. Blindage contre des hautes fréquences selon la revendication 1, caractérisé par le fait que
les parties coudées (3) aux extrémités du ressort
sont réalisées pour s'étendre dans la même direction et parallèlement au côté intérieur de l'élément de surface plane.

FIG 1

FIG 2

FIG 3

FIG 4